# EUROPEAN PATENT APPLICATION

(11) **EP 4 615 200 A1**
(43) Date of publication of application: **10.09.2025**
(21) Application number: 25159609.4
(22) Date of filing: 24.02.2025
(51) Int. Cl.: H10H 29/45, H10H 29/49, H10H 29/80, H10H 29/85

(54) **DISPLAY DEVICE AND TILED DISPLAY DEVICE**

(30) Priority: 29.02.2024 KR 20240030232
(71) Applicant: LG Display Co., Ltd., Seoul, 07336 (KR)
(72) Inventor: JEONG, Yeonjae, 10845 Paju-si (KR); PARK, JaeHyoung, 10845 Paju-si (KR)
(74) Representative: Viering, Jentschura & Partner mbB Patent- und Rechtsanwälte

(57) **Abstract**

Embodiments of the present disclosure relate to a display device (100) and a tiled display device, and more particularly, a display device (100) and a tiled display device comprising: a first substrate (200) including a display area (AA) and a non-display area (NA) surrounding the display area (AA); a light emitting device (230) provided in the display area (AA) on the first substrate (200); a first pad portion (220) provided in the non-display area (NA) on a top surface of the first substrate (200) and disposed on one edge of the first substrate (200); a second substrate (300) provided under a bottom surface of the first substrate (200); a second pad portion (320) provided in the non-display area (NA) on a bottom surface of the second substrate (300) and disposed on one edge of the second substrate (300); a side link line (420) electrically connecting the first pad portion (220) and the second pad portion (320); a side coating layer (430) disposed to cover the side link line (420); a side protective layer (500) disposed to cover at least a portion of the side coating layer (430); and a side sealing layer (440) disposed to cover at least a portion of the side protective layer (500).

## Description

### BACKGROUND

### Field

Embodiments of the present disclosure relate to a display device and a tiled display device.

### Discussion of Related Art

In recent years, display devices have become increasingly important with the development of multimedia. In response to this, display devices such as liquid crystal display devices, organic light emitting display devices, and light emitting diode display devices are being commercialized.

Display devices are widely used as display screens for televisions, laptops, and monitors, as well as portable electronic devices such as e-books, portable multimedia players (PMPs), GPS, mobile phones, smart phones, smart watches, tablet computers (PCs), watch phones, and mobile communication terminals, due to their excellent characteristics such as slimness, lightweight, and low power consumption.

Recently, there has been an increasing use of multi-display devices, where the display devices are arranged in a grid type to implement a large screen.

### SUMMARY OF THE DISCLOSURE

Embodiments of the present disclosure can provide a display device and a tiled display device that can prevent static electricity from entering the sides of the display modules.

Embodiments of the present disclosure can absorb light incident into gaps between adjacent display modules to provide a display device and a tiled display device where seams are not visible to a user.

Embodiments of the present disclosure can provide a display device and a tiled display device that can prevent moisture penetration to the sides of the display modules.

Various embodiments of the present disclosure provide a display device according to claim 1. Further embodiments are described in the dependent claims. Embodiments of the present disclosure can provide a display device comprising: a first substrate including a display area and a non-display area surrounding the display area; a light emitting device provided in the display area on the first substrate; a first pad portion provided in the non-display area on a top surface of the first substrate and disposed on one edge of the first substrate; a second substrate provided under a bottom surface of the first substrate; a second pad portion provided in the non-display area on a bottom surface of the second substrate and disposed on one edge of the second substrate; a side link line electrically connecting the first pad portion and the second pad portion; a side coating layer disposed to cover the side link line; a side protective layer disposed to cover at least a portion of the side coating layer; and a side sealing layer disposed to cover at least a portion of the side protective layer.

Embodiments of the present disclosure can provide a tiled display device comprising a plurality of display modules, each of the plurality of display modules comprising: a first substrate including a display area and a non-display area surrounding the display area; a light emitting device provided in the display area on the first substrate; a first pad portion provided in the non-display area on a top surface of the first substrate and disposed on one edge of the first substrate; a second substrate provided under a bottom surface of the first substrate; a second pad portion provided in the non-display area on a bottom surface of the second substrate and disposed on one edge of the second substrate; a side link line electrically connecting the first pad portion and the second pad portion; a side coating layer disposed to cover the side link line; a side protective layer disposed to cover at least a portion of the side coating layer; and a side sealing layer disposed to cover at least a portion of the side protective layer.

Embodiments of the present disclosure can provide a display device and a tiled display device that can prevent static electricity from entering the sides of the display module.

Embodiments of the present disclosure can absorb light incident into the gaps between adjacent display modules to provide display devices and tiled display devices in which seams are not visible to a user.

Embodiments of the present disclosure can provide a display device and a tiled display device that can prevent moisture penetration to the sides of the display module.

Embodiments of the present disclosure can provide a display device and a tiled display device capable of low power consumption by preventing static electricity and moisture from penetrating into the display module, thereby improving its lifespan.

### BRIEF DESCRIPTION OF DRAWINGS

FIG. 1 is a system structure diagram of a display device according to embodiments of the present disclosure.
FIG. 2 is an equivalent circuit of a subpixel in a display device according to embodiments of the present disclosure.
FIG. 3 is a view schematically illustrating a tiled display device according to embodiments of the present disclosure.
FIG. 4 is an exemplary cross-sectional view taken along the line A-B of FIG. 3.
FIG. 5 is a view schematically illustrating ESD flow in a display device according to embodiments of the present disclosure.
FIG. 6 is an exemplary cross-sectional view of a partial structure of a display device according to embodiments of the present disclosure.
FIG. 7 to FIG. 10 are other exemplary cross-sectional views of a partial structure of a display device according to embodiments of the present disclosure.
FIG. 11 to FIG. 17 are views schematically illustrating a manufacturing process for display devices according to embodiments of the present disclosure.

### DETAILED DESCRIPTIONS OF THE EMBODIMENTS

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the description may make the subject matter in some embodiments of the present disclosure rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after", "subsequent to", "next", "before" and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Various embodiments of the present disclosure will be described in detail with reference to the accompanying drawings.

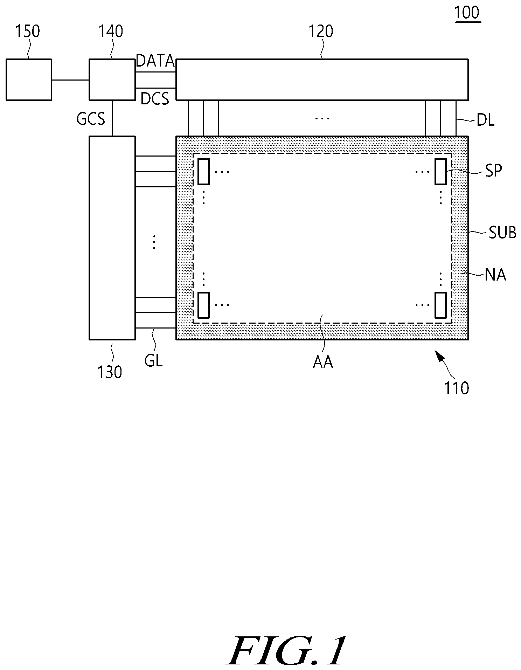

FIG. 1 is a system structure diagram of a display device 100 according to embodiments of the present disclosure.

Referring to FIG. 1, a display device 100 according to embodiments of the present disclosure may include a display panel 110, and drive circuit for driving the display panel 110.

The drive circuit may include a data drive circuit 120 and a gate drive circuit 130, and may further include a controller 140 that controls the data drive circuit 120 and the gate drive circuit 130.

The display panel 110 may include a substrate SUB, and signal lines such as a plurality of data lines DL and a plurality of gate lines GL disposed on the substrate SUB. The display panel 110 may include a plurality of subpixels SP associated with the plurality of data lines DL and the plurality of gate lines GL.

The display panel 110 may include a display area AA in which videos are displayed and a non-display area NA in which videos are not displayed. In the display panel 110, the display area AA may include a plurality of subpixels SP for displaying videos, and the non-display area NA may include a pad portion to which the driving circuits 120, 130, 140 are electrically connected or the driving circuits 120, 130, 140 are mounted, and to which integrated circuits or printed circuits or the like are connected.

The data drive circuit 120 is a circuit for driving a plurality of data lines DL, which can supply data signals to the plurality of data lines DL.

The gate drive circuit 130 is a circuit for driving a plurality of gate lines GL, and can supply gate signals to the plurality of gate lines GL.

The controller 140 may supply data control signals DCS to the data drive circuit 120 for controlling the driving timing of the data drive circuit 120, and may supply gate control signals GCS to the gate drive circuit 130 for controlling the driving timing of the gate drive circuit 130.

The controller 140 may initiate scanning according to timing implemented by each frame, convert externally input image data to a data signal format used by the data drive circuit 120, supply the converted image data Data to the data drive circuit 120, and control the driving of data at an appropriate time according to the scan.

Along with the input image data, the controller 140 receives various timing signals, including a vertical synchronization signal VSYNC, a horizontal synchronization signal HSYNC, an input data enable signal DE, and a clock signal CLK, from an external source (e.g., the host system 150).

The controller 140 receives timing signals such as a vertical synchronization signal VSYNC, a horizontal synchronization signal HSYNC, an input data enable signal DE, and a clock signal CLK to control the data drive circuit 120 and the gate drive circuit 130, and generates various control signals DCS, GCS to output to the data drive circuit 120 and the gate drive circuit 130.

For example, the controller 140 outputs various gate control signals GCS, including a gate start pulse GSP, a gate shift clock GSC, a gate output enable signal GOE, and the like, to control the gate drive circuit 130.

In addition, the controller 140 outputs various data control signals DCS, including a source start pulse SSP, a source sampling clock SSC, a source output enable signal SOE, and the like, to control the data drive circuit 120.

The controller 140 may be implemented as a separate component from the data drive circuit 120, or it may be integrated with the data drive circuit 120 to form an integrated circuit.

The data drive circuit 120 receives image data from the controller 140 and drives the plurality of data lines DL by supplying data voltages to the plurality of data lines DL. The data drive circuit 120 is also referred to as the source drive circuit.

Such data drive circuit 120 may include one or more source driver integrated circuits (SDICs).

Each source driver integrated circuit (SDIC) may include a shift register, a latch circuit, a digital to analog converter (DAC), an output buffer, and the like. Each source driver integrated circuit (SDIC) may further include, in some cases, an analog to digital converter (ADC).

For example, each source driver integrated circuit (SDIC) may be connected to the display panel 110 by tape automated bonding (TAB), may be connected to a bonding pad on the display panel 110 by chip on glass (COG) or chip on panel (COP), or may be implemented in a chip on film (COF) type to be connected to the display panel 110.

The gate drive circuit 130 may output a gate signal of a turn-on level voltage or may output a gate signal of a turn-off level voltage, depending on the control of the controller 140. The gate drive circuit 130 can sequentially drive a plurality of gate lines GL by sequentially supplying gate signals of the turn-on level voltage to the plurality of gate lines GL.

The gate drive circuit 130 may be connected to the display panel 110 in a tape automated bonding (TAB) type, or connected to a bonding pad of the display panel 110 in a chip-on-glass (COG) or chip-on-panel (COP) type, or connected to the display panel 110 in a chip-on-film (COF) type. Alternatively, the gate drive circuit 130 may be formed in the non-display area NA of the display panel 110 by a gate in panel (GIP) type. The gate driving circuit 130 may be disposed on or connected to the substrate SUB, i.e., the gate driving circuit 130 may be disposed in the non-display area NA of the substrate SUB if the gate driving circuit 130 is a GIP type. The gate drive circuit 130 may be connected to the substrate SUB if it is a chip-on-glass (COG) type, a chip-on-film (COF) type, or the like.

On the other hand, the driving circuit of at least one of the data driving circuit 120 and the gate driving circuit 130 may be disposed in the display area AA.

For example, the gate drive circuit 130 may be disposed in the display area AA. In this case, the gate drive circuit 130 may be disposed across the entirety of the display area AA or may be disposed in only a portion of the display area AA. The gate drive circuit 130 may be disposed non-overlapping with the subpixels SP, or may be disposed partially or fully overlapping with the subpixels SP.

In another example, the data drive circuit 120 may be disposed in the display area AA. In this case, the data drive circuit 120 may be disposed throughout the entirety of the display area AA or may be disposed in only a portion of the display area AA. The data drive circuit 120 may be disposed non-overlapping with the subpixels SP, or may be disposed partially or fully overlapping with the subpixels SP.

When a particular gate line GL is selected by the gate drive circuit 130, the data drive circuit 120 may convert the image data received from the controller 140 into data voltages of analog form and supply them to a plurality of data lines DL.

The data drive circuit 120 may be connected to one side (e.g., top side or bottom side) of the display panel 110. Depending on how it is driven, how the panel is designed, etc., the data drive circuit 120 may be connected to both sides (e.g., top side and bottom side) of the display panel 110, or it may be connected to two or more of the four lateral sides of the display panel 110.

The gate drive circuit 130 may be connected to one side (e.g., left or right) of the display panel 110. Depending on how it is driven, how the panel is designed, etc., the gate drive circuit 130 may be connected to both sides (e.g., left and right) of the display panel 110, or may be connected to two or more of the four lateral sides of the display panel 110.

The controller 140 may be a timing controller as utilized in conventional display technology, or it may be a control device that may perform other control functions in addition to the timing control, or it may be a different control device than the timing controller, or it may be a circuit within the control device. The controller 140 may be implemented as a variety of circuits or electronic components, such as an integrated circuit (IC), a field programmable gate array (FPGA), an application specific integrated circuit (ASIC), or a processor.

The controller 140 may be mounted on a printed circuit board, flexible printed circuit, or the like, and may be electrically connected to the data drive circuit 120 and the gate drive circuit 130 via the printed circuit board, flexible printed circuit, or the like.

The controller 140 may transmit and receive signals to and from the data drive circuit 120 according to one or more predetermined interfaces. Here, for example, the interfaces may include a low voltage differential signaling (LVDS) interface, an embedded clock point to point interface (EPI), a serial peripheral interface (SPI), and the like.

The controller 140 may include a memory medium, such as one or more registers.

The display device 100 according to embodiments of the present disclosure may be a display device in which the display panel 110 is not capable of illuminating itself. For example, the display device 100 according to embodiments of the present disclosure may be a liquid crystal display device that includes backlight units.

Alternatively, the display device 100 according to embodiments of the present disclosure may be a self-illuminating display device in which the display panel 110 is capable of illuminating itself. For example, the display device 100 according to embodiments of the present disclosure may be one of an organic light emitting diode (OLED) display, a quantum dot (QD) display, a micro light emitting diode (micro LED) display, and the like.

When the display device 100 according to embodiments of the present disclosure is an organic light emitting diode display device, each subpixel SP may include an organic light emitting diode (OLED) that emits light by itself as a light emitting device. If the display device 100 according to embodiments of the present disclosure is a quantum dot display device, each subpixel SP may include a light emitting device made of a quantum dot, which is a semiconductor crystal that emits light by itself. When the display device 100 according to embodiments of the present disclosure is a micro light emitting diode display device, each subpixel SP may include a micro light emitting diode as a light emitting device, which is a semiconductor crystal that emits light by itself and is made of inorganic materials.

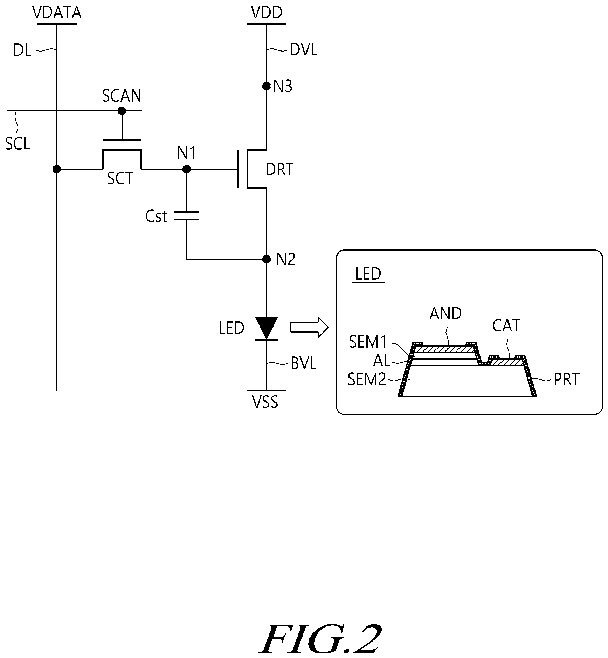

FIG. 2 is an equivalent circuit of a subpixel SP in a display device 100, in accordance with embodiments of the present disclosure.

Referring to FIG. 2, the display panel 110 may include a plurality of subpixels SP formed on a substrate SUB.

Each of the plurality of subpixels SP may include a light emitting diode LED as a light emitting device, a drive transistor DRT for driving the light emitting diode LED, a scan transistor SCT for transmitting a data voltage VDATA to a first node N1 of the drive transistor DRT, and a storage capacitor Cst for maintaining a constant voltage during a frame.

The drive transistor DRT may include a first node N1 to which a data voltage VDATA may be applied, a second node N2 electrically connected with a light emitting diode LED, and a third node N3 to which a first power signal VDD is applied from a first power line DVL. In the drive transistor DRT, the first node N1 may be a gate node, the second node N2 may be a source node or a drain node, and the third node N3 may be a drain node or a source node.

A light emitting diode LED may also be referred to as a light emitting diode chip (LED chip). For example, a light emitting diode LED can also be a micro light emitting diode or micro light emitting diode chip.

The light emitting diode LED may include a first semiconductor layer SEM1, a second semiconductor layer SEM2, and an active layer AL. The first semiconductor layer SEM1 may be formed on at least a portion of the surface of the second semiconductor layer SEM2, exposing at least other portion of the surface of the second semiconductor layer SEM2. An active layer AL may be interposed between the first semiconductor layer SEM1 and the second semiconductor layer SEM2. Here, the active layer AL may also be referred to as a light emitting layer. The light emitting diode LED may further include a first electrode AND and a second electrode CAT.

The first electrode AND may be formed on the first semiconductor layer SEM1, which may be electrically connected to the first semiconductor layer SEM1. The second electrode CAT may be formed on the exposed second semiconductor layer SEM2, which may be electrically connected to the second semiconductor layer SEM2. The first electrode AND and the second electrode CAT may be disposed at a predetermined spacing apart.

The first semiconductor layer SEM1 may be implemented as a p-type semiconductor layer.

The second semiconductor layer SEM2 may be implemented as an n-type semiconductor layer.

The active layer AL may be a layer in which holes injected through the first semiconductor layer SEM1 and electrons injected through the second semiconductor layer SEM2 meet each other and emit light due to the band gap difference of energy bands depending on the forming material of the active layer AL.

The light emitting diode LED may further include an insulating film PRT for protecting its elements. The insulating film PRT may cover an exposed outer surface of the light emitting diode LED, but may expose at least a portion of the first electrode AND and at least a portion of the second electrode CAT. The insulating film PRT may include an insulating material. For example, the PRT may include any one of silicon oxide (SiOx) film and silicon nitride (SiNx) film, or laminated structure thereof.

Meanwhile, the first electrode AND of the light emitting diode (LED) may be electrically connected with the pixel electrode, and the second electrode CAT of the light emitting diode LED may be electrically connected with a common electrode.

Pixel electrodes may be disposed at each subpixel SP, and may be electrically connected with the second node N2 of the drive transistor DRT of each subpixel SP. A common electrode may be disposed common to a plurality of subpixels SPs.

The display panel 110 may further include a second power line BVL for supplying a second power signal VSS to the common electrode, the second power line BVL being electrically connected to the common electrode.

In another example, the light emitting diode (LED) may be an organic light emitting diode (OLED) including an organic light emitting layer between the first electrode AND and the second electrode CAT.

The scan transistor SCT is connected between the first node N1 of the drive transistor DRT and the corresponding data line DL, and can control the voltage state of the first node N1 of the drive transistor DRT.

The scan transistor SCT may control the connection between the first node N1, which is the gate node of the drive transistor DRT, and the corresponding data line DL of the plurality of scan lines SCL, according to a scan signal SCAN supplied from the corresponding scan line SCL, which is a type of gate line GL.

The drain node or source node of the scan transistor SCT may be electrically connected to a corresponding data line DL. The source node or drain node of the scan transistor SCT may be electrically connected to the first node N1 of the drive transistor DRT. The gate node of the scan transistor SCT may be electrically connected to the scan line SCL to receive a scan signal SCAN.

The scan transistor SCT may be turned on by a scan signal SCAN at a turn-on level voltage, and may transmit a data voltage VDATA supplied from corresponding data line DL to the first node N1 of the drive transistor DRT.

The scan transistor SCT is turned on by a scan signal SCAN with a turn-on level voltage and turned off by a scan signal SCAN with a turn-off level voltage. Here, if the scan transistor SCT is n-type, the turn-on level voltage may be a high-level voltage and the turn-off level voltage may be a low-level voltage. If the scan transistor SCT is p-type, the turn-on level voltage may be a low-level voltage and the turn-off level voltage may be a high-level voltage.

The storage capacitor Cst may be electrically connected between the first node N1 and the second node N2 of the drive transistor DRT. The storage capacitor Cst may be an external capacitor that is intentionally designed on the outside of the driving transistor DRT, rather than a parasitic capacitor (e.g., Cgs, Cgd), which is an internal capacitor that may be present between the first node N1 and the second node N2 of the driving transistor DRT.

Each of the drive transistor DRT and scan transistor SCT can be either an n-type transistor or a p-type transistor.

As illustrated in FIG. 2, each subpixel SP may have a 2T(Transistor)1C(Capacitor) structure including two transistors DRT, SCT and one capacitor Cst, and in some cases, may additionally include one or more transistors, or one or more capacitors.

The display device 100 may have a top emission structure in which light is emitted to the opposite direction of the substrate SUB of the display panel 110.

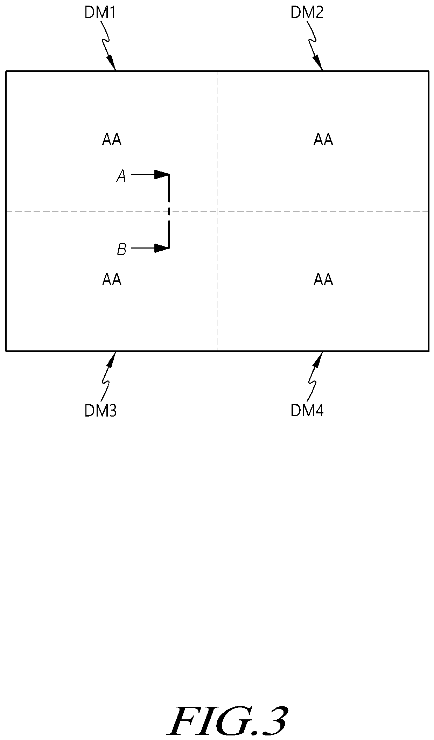

FIG. 3 is a view schematically illustrating a tiled display device according to embodiments of the present disclosure.

Referring to FIG. 3, a tiled display device according to one embodiment of the present disclosure may include a plurality of display modules DM1, DM2, DM3, DM4.

Each of the plurality of display modules DM1, DM2, DM3, DM4 may display an individual video or may display a single video in segments. Each of the plurality of display modules DM1, DM2, DM3, DM4 includes a display device 100 according to the embodiments of the present disclosure shown in FIG. 1, which will not be described redundantly.

Each of the plurality of display modules DM1, DM2, DM3, DM4 may be tiled in a separate tiling frame such that their sides are in contact with each other. For example, each of the plurality of display modules DM1, DM2, DM3, DM4 may be tiled to have an N×M shape to realize a multi-screen display device of a large screen. For example, N may be a positive integer greater than or equal to 1 and M may be a positive integer greater than or equal to 2. Alternatively, for example, N can be a positive integer greater than or equal to 2 and M can be a positive integer greater than or equal to 1.

Each of the plurality of display modules DM1, DM2, DM3, DM4 may have an air bezel structure in which the display area AA is surrounded by air, without including a bezel area (or non-display area) surrounding the entire display area AA on which the video is displayed. That is, each of the plurality of display modules DM1, DM2, DM3, DM4 may be implemented such that the entire first side of the first substrate 200 is the display area AA.

The tiled display device may be configured by combining a plurality of display modules DM1, DM2, DM3, DM4. In this case, the sides of each of the display modules may be subject to external foreign materials or moisture. The moisture may be introduced in a liquid or gaseous state. Furthermore, the moisture may be introduced in the form of water droplets or water vapor, and may also be introduced in the form of a smaller size than water vapor. Moisture can enter the empty space on the side of the display module, or directly into the side coating layer or the side sealing layer. To prevent such moisture from entering, the empty space in the side of the display module can be filled or the side coating layer or the side sealing layer can be treated with a moisture-proof treatment. However, even in this case, there is the problem that moisture, including shapes that are smaller than water vapor, can be introduced.

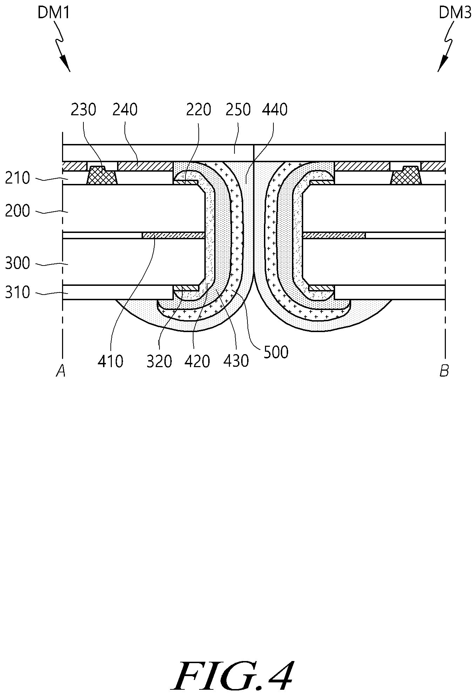

FIG. 4 is an exemplary cross-sectional view taken along the line A-B of FIG. 3. Specifically, FIG. 4 may illustrate a cross-sectional view of a portion where the first display module DM1 and the third display module DM3 are in contact.

Referring to FIG. 4, the first display module DM1 may include a first substrate 200, a first layer 210, a first pad portion 220, a light emitting device 230, a second layer 240, a functional film layer 250, a second substrate 300, a third layer 310, a second pad portion 320, an adhesive layer 410, a side link line 420, a side coating layer 430, a side sealing layer 440, and a side protective layer 500. In this case, the remaining plurality of display modules, including the second display module DM2, may be substantially identical to the structure of the first display module DM1, and may be configured differently in part as needed.

The first substrate 200 is a base substrate for supporting the various components of the first display module DM1, which may be an insulating substrate. The first substrate 200 may be composed of glass or plastic. The first substrate 200 may also be formed of a material having flexibility to allow for bending.

A display area AA and a non-display area NA surrounding the display area AA may be defined on the first substrate 200. The display area AA is the area where the video is actually displayed on the display panel 200, and the light emitting device 230 may be disposed in the display area AA. The non-display area NA is an area in which the video is not displayed, and may be defined as an area surrounding the display area AA.

A first layer 210 may be disposed on the first substrate 200. A plurality of insulating layers and a plurality of signal lines may be disposed on the first layer 210. Various transistors and capacitors described above may be disposed on the first layer 210.

In the non-display area NA of the first substrate 200, a first pad portion 220 may be disposed in connection with various signal lines. The first pad portion 220 may be disposed at one edge of the non-display area NA. The first pad portion 220 may be in electrical connection with the side link line 420, which will be described later. The first pad portion 220 may be a metal layer extending from the plurality of signal lines.

On the first layer 210 may be disposed a light emitting device 230 and a second layer 240 surrounding the light emitting device 230. As described above, the light emitting device 230 may be a light emitting diode (LED) or a micro light emitting diode (µLED).

The second layer 240 may include a plurality of planarization layers and insulating layers.

A functional film layer 250 may be disposed on the second layer 240. The functional film layer 250 may include an anti-reflective layer (or anti-reflective film) for preventing reflection of external light to improve outdoor visibility and contrast for images displayed on the display device. The functional film layer 250 may include a barrier layer (or barrier film) to primarily prevent moisture or oxygen penetration. The functional film layer 250 may further include a light path control layer (or light path control film) to control the path of light emitted from each pixel P towards the outside.

Under the first substrate 200, a second substrate 300 may be disposed. The second substrate 300 may be an insulating substrate that supports components disposed on the lower portion of the display device. For example, it may be composed of glass or plastic. The second substrate 300 may also be formed of a material having flexibility to allow for bending. The second substrate 300 may be formed of the same material as the first substrate 200.

A third layer 310 may be disposed on the backside of the second substrate 300. A plurality of insulating layers and a plurality of link lines may be disposed on the third layer 310.

A second pad portion 320 may be disposed on one edge of the second substrate 300. The second pad portion 320 may be a region in electrical connection with the side link line 420, which will be described later. The second pad portion 320 may be a metal layer extending from the plurality of link lines.

An adhesive layer 410 may be disposed between the first substrate 200 and the second substrate 300. The adhesive layer 410 may bond the first substrate 200 and the second substrate 300. The adhesive layer 410 may be made of a material that can be cured through various curing methods to bond the first substrate 200 and the second substrate 300. The adhesive layer 410 may be disposed over a portion of the area between the first substrate 200 and the second substrate 300, or it may be disposed over the entire area.

Referring to FIG. 4, side link line 420 may be disposed on the sides of the first substrate 200 and the second substrate 300. The side link line 420 may include a plurality of link lines. The side link line 420 may electrically connect a plurality of signal lines disposed on a top surface of the first substrate 200 and a plurality of link lines disposed on a back surface of the second substrate 300. The side link line 420 may be disposed to cover the ends of the plurality of signal lines disposed on the top surface of the first substrate 200, the sides of the first substrate 200 and the second substrate 300, and the ends of the plurality of link lines disposed on the back surface of the second substrate 300. In other words, the side link line 420 may be disposed to continuously cover the first pad portion 220 to which the plurality of signal lines are connected, the sides of the first substrate 200 and the second substrate 300, and the second pad portion 320 to which the plurality of link lines are connected.

The side link line 420 may be made of a patterned metal layer, such that the respective signal lines and the respective link lines corresponding thereto are connected. In this case, the patterned metal layer may be formed by a printing method utilizing a conductive paste. For example, the side link line 420 may be formed by a pad printing method utilizing silver (Ag) paste, but embodiments of the present disclosure are not limited thereto.

Referring to FIG. 4, a side coating layer 430 may be disposed to cover the side link line 420. The side coating layer 430 may be disposed to cover not only the side link line 420, but also a portion of one edge of a side of the first substrate 200, and a portion of one edge of a side of the second substrate 300 altogether. The side coating layer 430 may prevent corrosion of each of the link lines made of conductive material or electrical shorts between the individual link lines of the side link line 420. Further, the side coating layer 430 may prevent or minimize reflection of external light by the side link line 420 and the pads of the first pad portion 220. The side coating layer 430 can include a black ink comprising at least one of carbon black, a black dye, and a black pigment. The side coating layer 430 may be formed by a printing method utilizing black ink. For example, the side coating layer 430 may be formed by a pad printing method utilizing a black ink comprising carbon black, but embodiments of the present disclosure are not limited thereto.

Referring to FIG. 4, a side protective layer 500 may be disposed to cover the side coating layer 430. The side protective layer 500 may be disposed to cover not only the side coating layer 430, but also a portion of one edge of a side of the first substrate 200, and a portion of one edge of a side of the second substrate 300 altogether. The side protective layer 500 may include a plurality of layers. The side protective layer 500 may include a moisture barrier material. The side protective layer 500 may include a conductive material. The side protective layer 500 may include a light absorbing material. The side protective layer 500 may prevent static electricity from entering the sides of the display module. The side protective layer 500 may absorb light incident into a gap between neighboring display modules so that the seam is not visible to a user. The side protective layer 500 can prevent moisture from entering the sides of the display module.

The moisture barrier material may include an aromatic hydrocarbon-based compound. The moisture barrier material may include a deposition powder of an aromatic hydrocarbon-based compound. The moisture barrier material may include an aromatic hydrocarbon-based compound formed by the parylene coating method.

The aromatic hydrocarbon-based compound may be at least one selected from the following compounds.

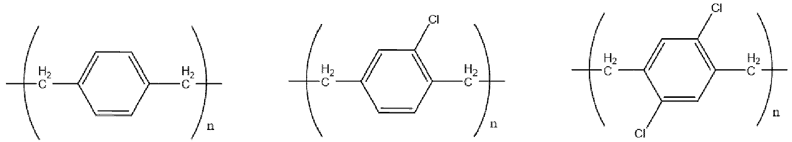

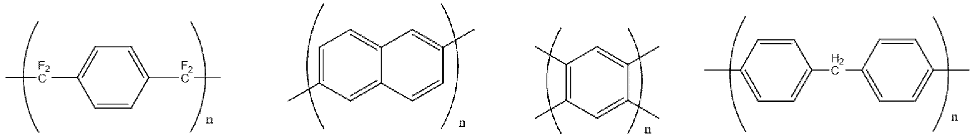

The conductive material may include conductive particles and conductive polymers.

The conductive particles may be carbon nanotubes. The carbon nanotube may be at least one selected from single-walled carbon nanotubes, double-walled carbon nanotubes, and multi-walled carbon nanotubes.

Conductive polymers may be at least one selected from the group consisting of polyfluorene, polyphenylene, polypyrene, polyazulene, polynaphthalene, polyacetylene (PAC), poly(p-phenylene vinylene) (PPV), polypyrrole (PPY), polycarbazole, polyindole, polyzepine, poly(thienylene vinylene), polyaniline (PANI), poly(thiophene), poly(p-phenylene sulfide) (PPS), poly(3,4-ethylenedioxy thiophene) (PEDOT), poly(3,4-ethylenedioxy thiophene) doped with poly(styrene sulfonate) (PEDOT:PSS), poly(3,4-ethylenedioxythiophene)-tetramethacrylate (PEDOT-TMA) and polyfuran.

The conductive material may include conductive particles and black rubber.

The conductive particles can be the same as the carbon nanotubes described above.

The black rubber may include at least one of carbon black, a black dye and a black pigment, and an isoprene-based rubber.

The light absorbing material may be a black ink. The black ink may include at least one of carbon black, black dye and black pigment.

Referring to FIG. 4, a side sealing layer 440 may be disposed to cover the side protective layer 500. The side sealing layer 440 may be disposed to cover not only the side protective layer 500, but also a portion of one edge of a side of the first substrate 200, and a portion of one edge of a side of the second substrate 300. The side sealing layer 440 may prevent corrosion of each of the link lines made of conductive material or electrical shorts between the individual link lines of the side link line 420. Further, the side sealing layer 440 may prevent or minimize reflection of external light by the side link line 420 and the pads of the first pad portion 220. The side sealing layer 440 may include at least one of carbon black, a black dye and a black pigment. The side sealing layer 440 may fill the space formed between the functional film layer 250 and the sides of the display module. Accordingly, the side sealing layer 440 may prevent foreign materials or moisture from entering the space between the substrate 200, 300 and the functional film layer 250 from the outside.

Referring to FIG. 4, a side end of the functional film layer 250 and a side end of the side sealing layer 440 may be disposed on the same line. By disposing the side ends of the functional film layer 250 and the side ends of the side sealing layer 440 on the same line, a gap formed between the display modules can be minimized, and a seam caused by the gap can be minimized.

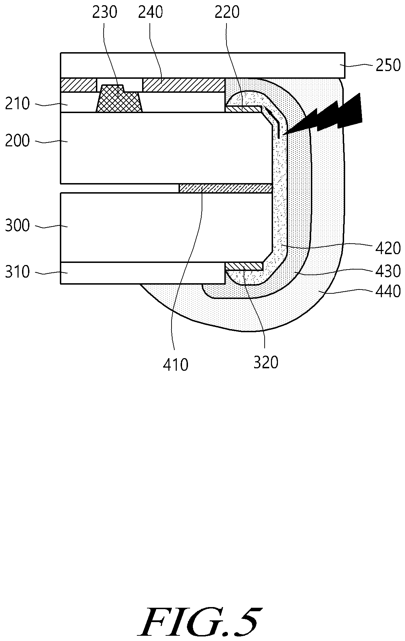

FIG. 5 is a view schematically illustrating ESD (Electro-Static Discharge) flow in a display device according to embodiments of the present disclosure.

FIG. 5 may be substantially the same as one aspect of the display device shown in FIG. 4, except that the side protective layer 500 is not disposed between the side coating layer 430 and the side sealing layer 440.

Referring to FIG. 5, when static electricity is generated from the outside, static electricity may be introduced into a thin portion of the side coating layer 430 and the side sealing layer 440, which are insulating layers, and transferred to the side link line 420. The introduced static electricity may flow along the side link line 420 formed including silver (Ag) to various lines arranged on the display panel. In this case, if static electricity exceeds the capacity of the antistatic circuit disposed in the display panel, the lines may be damaged.

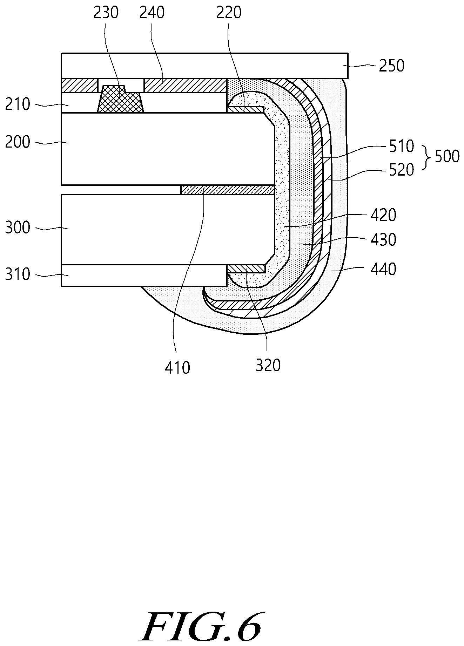

FIG. 6 is an exemplary cross-sectional view of a partial structure of a display device according to embodiments of the present disclosure.

Referring now to FIG. 6, it will be appreciated that the side protective layer 500 may be substantially the same as that illustrated in FIG. 4, except that the side protective layer 500 includes a first side protective layer 510 and a second side protective layer 520, so that duplicative description may be omitted or shortened.

Referring to FIG. 6, the side protective layer 500 may include a first side protective layer 510 and a second side protective layer 520.

The first side protective layer 510 may include a moisture barrier material. The moisture barrier material may be the same as the moisture barrier material included in the side protective layer 500 described in FIG. 4.

The second side protective layer 520 may include a conductive material. The conductive material may include conductive particles and conductive polymers. The conductive particles and conductive polymer may be the same as the conductive particles and conductive polymer included in the side protective layer 500 described in FIG. 4.

Referring to FIG. 6, the first side protective layer 510 may be disposed abutting the side coating layer 430, the second side protective layer 520 may be disposed abutting the first side protective layer 510, and the side sealing layer 440 may be disposed abutting the second side protective layer 520.

The first side protective layer 510 may be a parylene coating layer. A parylene coating layer is a coating layer that is formed on a base material at room temperature using at least one parylene dimer selected from parylene-based compounds. In this case, the parylene dimers may be used singly or optionally in a mixture.

The first side protective layer 510 may include a moisture barrier material. The first side protective layer 510 may include a deposition powder of an aromatic hydrocarbon-based compound. The first side protective layer 510 may include an aromatic hydrocarbon-based compound formed by a parylene coating method. The first side protective layer 510 may be formed with a parylene coating layer including a moisture barrier material to prevent moisture from penetrating from the outside to the inside of the display module. The first side protective layer 510 may have a moisture-proof function as well as an anti-moisture penetration function.

The second side protective layer 520 may be formed by a pad printing method. For example, the second side protective layer 520 may be formed by a mixture of multi-walled carbon nanotubes which are conductive particles, and PEDOT:PSS which is a conductive polymer, using a pad unit comprising a silicone pad and a head.

The second side protective layer 520 may be formed including conductive particles and conductive polymers to prevent static electricity from entering from the outside.

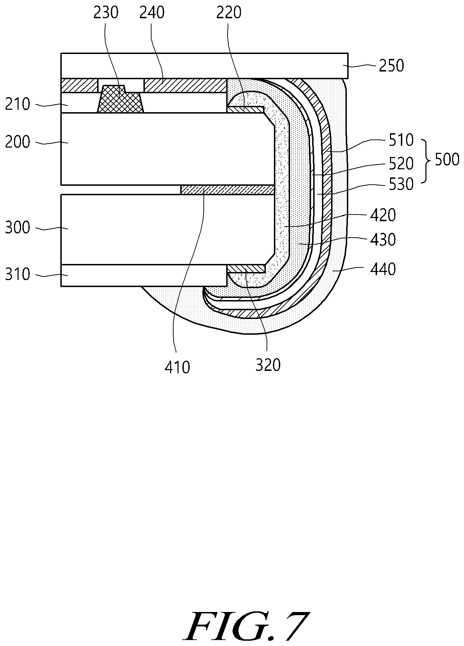

FIG. 7 to FIG. 10 are other exemplary cross-sectional views of a partial structure of a display device according to embodiments of the present disclosure.

Referring now to FIG. 7, the side protective layer 500 includes a third side protective layer 530, and may be substantially the same as that illustrated in FIG. 6 except for the order of placement of the layers comprising the side protective layer 500, so that duplicative description may be omitted or shortened.

Referring to FIG. 7, the side protective layer 500 may include a first side protective layer 510, a second side protective layer 520, and a third side protective layer 530.

The third side protective layer 530 may include a light absorbing material. The light absorbing material may be the same as the light absorbing material included in the side protective layer 500 described in FIG. 4.

Referring to FIG. 7, the first side protective layer 510 may be disposed abutting the third side protective layer 530, the third side protective layer 530 may be disposed abutting the second side protective layer 520, and the side sealing layer 440 may be disposed abutting the first side protective layer 510.

The second side protective layer 520 may be disposed abutting the side coating layer 430, the third side protective layer 530 may be disposed abutting the second side protective layer 520, the first side protective layer 510 may be disposed abutting the third side protective layer 530, and the side sealing layer 440 may be disposed abutting the first side protective layer 510.

The third side protective layer 530 may be formed by a pad printing method. For example, the third side protective layer 530 may be formed by printing black ink including carbon particles which is a light absorbing material, using a pad unit comprising a silicone pad and a head.

The third side protective layer 530 may be formed including a light absorbing material to absorb light incident into the gap between adjacent display modules so that the seam is not visible to a user.

Referring now to FIG. 7, the side protective layer 500 includes a third side protective layer 530, and may be substantially the same as that illustrated in FIG. 6 except for the order of placement of the layers comprising the side protective layer 500, so that duplicative description may be omitted or shortened.

Referring to FIG. 7, the side protective layer 500 may include a first side protective layer 510, a second side protective layer 520, and a third side protective layer 530.

The third side protective layer 530 may include a light absorbing material. The light absorbing material may be the same as the light absorbing material included in the side protective layer 500 described in FIG. 4.

Referring to FIG. 7, the first side protective layer 510 may be disposed abutting the third side protective layer 530, the third side protective layer 530 may be disposed abutting the second side protective layer 520, and the side sealing layer 440 may be disposed abutting the first side protective layer 510.

The second side protective layer 520 may be disposed abutting the side coating layer 430, the third side protective layer 530 may be disposed abutting the second side protective layer 520, the first side protective layer 510 may be disposed abutting the third side protective layer 530, and the side sealing layer 440 may be disposed abutting the first side protective layer 510.

The third side protective layer 530 may be formed by a pad printing method. For example, the third side protective layer 530 may be formed by applying black ink comprising carbon particles which is a light absorbing material, using a pad unit comprising a silicone pad and a head.

The third side protective layer 530 may be formed including a light absorbing material to absorb light incident into the gap between adjacent display modules so that the seam is not visible to a user.

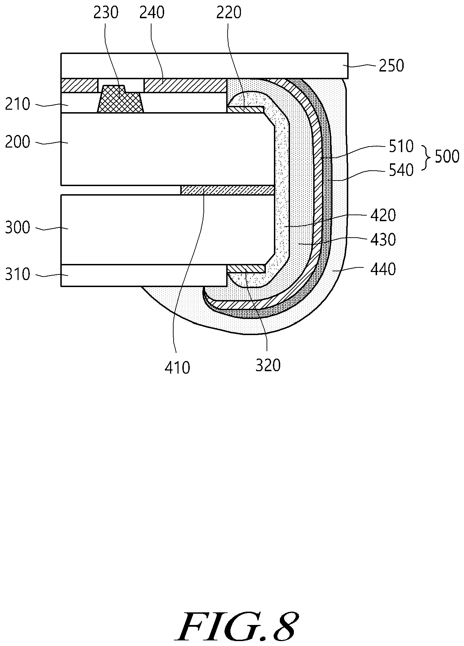

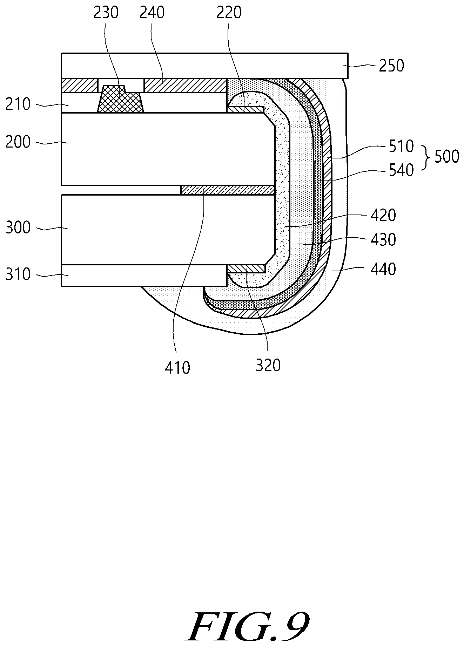

Referring to FIG. 8 and FIG. 9, the side protective layer 500 may include a first side protective layer 510 and a fourth side protective layer 540.

The first side protective layer 510 is identical to the first side protective layer 510 described in FIG. 6, and therefore will not be described in detail.

The fourth side protective layer 540 may include a conductive material. The conductive material may include conductive particles and black rubber. The conductive particles and black rubber may be the same as the conductive particles and black rubber included in the side protective layer 500 described in FIG. 4.

Referring to FIG. 8, the first side protective layer 510 may be disposed abutting the side coating layer 430, the fourth side protective layer 540 may be disposed abutting the first side protective layer 510, and the side sealing layer 440 may be disposed abutting the fourth side protective layer 540.

By forming the fourth side protective layer 540 to include conductive particles and black rubber, static electricity can be prevented from entering from the outside.

Referring to FIG. 9, the fourth side protection layer 540 may be disposed abutting the side coating layer 430, the first side protection layer 510 may be disposed abutting the fourth side protection layer 540, and the side sealing layer 440 may be disposed abutting the first side protection layer 510.

By forming the fourth side protective layer 540 to include conductive particles and black rubber, static electricity can be prevented from entering from the outside.

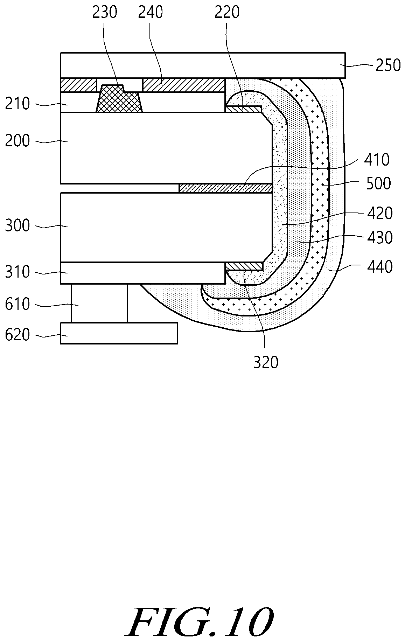

Referring to FIG. 10, which may be substantially the same as that illustrated in FIG. 4 except for the inclusion of the adhesive pad 610 and the cover bottom 620, duplicative description may be omitted or shortened.

Referring to FIG. 10, an adhesive pad 610 and a cover bottom 620 may be disposed on the third layer 310.

The cover bottom 620 may be disposed to enclose the display panel to prevent impact or foreign material from penetrating from the outside. The cover bottom 620 may be formed of a polymeric material, such as polypropylene or polyethylene, and may be a stretchable material.

Referring to FIG. 10, the side protective layer 500 disposed on the side may not extend to the adhesive pad 610 or the cover bottom 620. The side protective layer 500, according to embodiments of the present disclosure, may include a conductive material comprising conductive particles and a conductive polymer, or a conductive material comprising conductive particles and black rubber, to prevent the introduction of externally generated static electricity. Accordingly, a plastic cover bottom 620 including a polymeric material may be applied to replace the cover bottom that typically utilizes a metallic material.

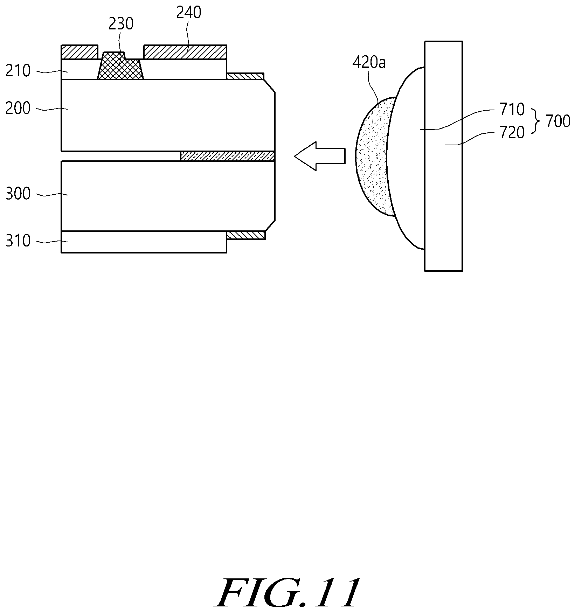

FIG. 11 to FIG. 17 are views schematically illustrating a manufacturing process for display devices according to embodiments of the present disclosure.

Referring to FIG. 11, side link line 420 can be formed on the sides of the display panel. The side link line 420 can be formed using a pad unit 700 comprising a silicone pad 710 and a head 720, and a conductive paste 420a. Specifically, the conductive paste 420a can be attached to the silicone pad 710. Then, the pad unit 700 can be moved to a side of the display panel to move the silicone pad 710 to the side of the display panel where the side link line 420 can be to be formed. The conductive paste 420a attached to the silicone pad 710 can be then transferred to the side of the display panel to form the side link line 420.

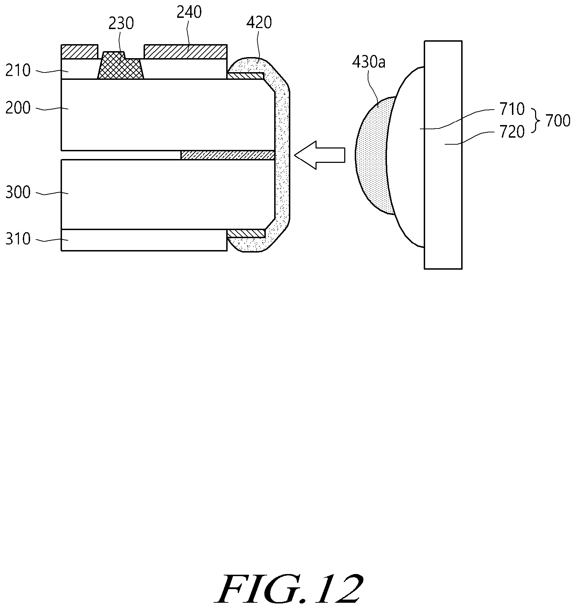

Referring to FIG. 12, a side coating layer 430 can be formed on the side of the display panel. The side coating layer 430 can be formed using a pad unit 700 comprising a silicone pad 710 and a head 720, and a black ink composition 430a. Specifically, the black ink composition 430a can be attached to the silicone pad 710. Thereafter, the pad unit 700 can be moved to a side of the display panel to move the silicone pad 710 to the side of the display panel where the side coating layer 430 can be to be formed. The black ink composition 430a attached to the silicone pad 710 can be then transferred to the side of the display panel to form the side coating layer 430.

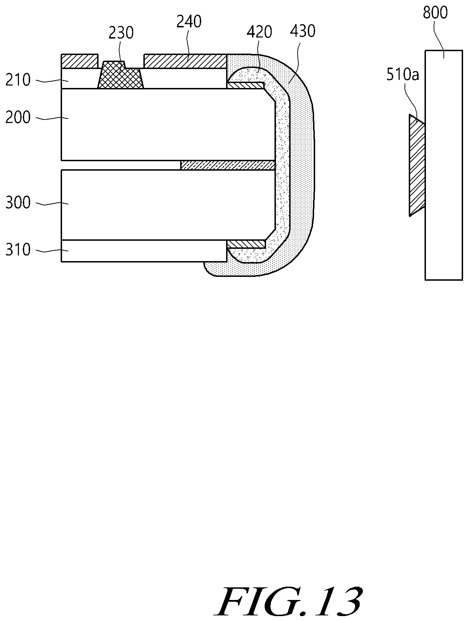

Referring to FIG. 13, a first side protective layer 510 may be formed on a side of the display panel. The first side protective layer 510 may be formed using a parylene coating method. The parylene-based dimer 510a, which can be an aromatic hydrocarbon-based compound, can be heated and vaporized in the depositor 800. The parylene-based dimer can be then pyrolyzed at high temperature to form a parylene-based monomer, and the pyrolyzed parylene-based monomer can be then deposited at room temperature to form the first side protective layer 510.

When the first side protective layer 510 is formed using a deposition powder of an aromatic hydrocarbon-based compound, it can be coated in a uniform form and can be densely coated according to the shape of the material to be coated. Furthermore, when the deposition powder of the aromatic hydrocarbon-based compound is coated on the material to be coated by parylene coating method, the thickness of the coating layer can be easily controlled while not subjecting the material to be coated to thermal stress.

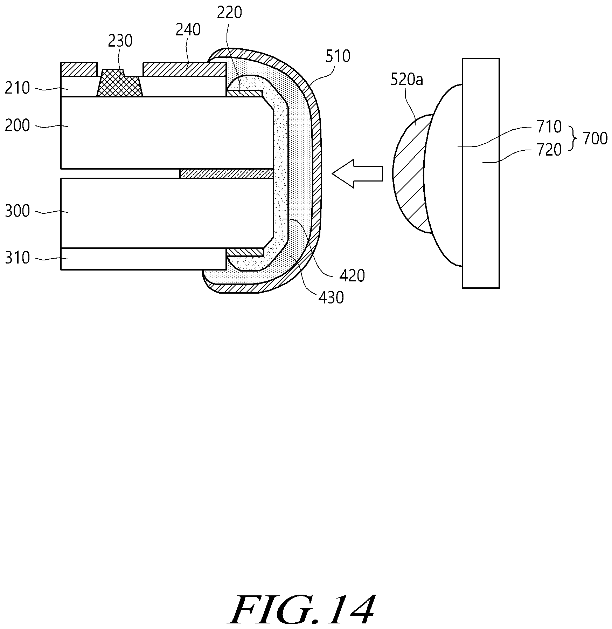

Referring to FIG. 14, a second side protective layer 520 can be formed on the side of the display panel. The second side protective layer 520 can be formed using a pad unit 700 comprising a silicone pad 710 and a head 720, and a conductive material 520a. Specifically, the conductive material 520a can be attached to the silicone pad 710, and then the pad unit 700 can be moved to the side of the display panel to move the silicone pad 710 to the side of the display panel where the second side protective layer 520 can be to be formed. Thereafter, the conductive material 520a attached to the silicone pad 710 can be transferred to the side of the display panel to form the second side protective layer 520.

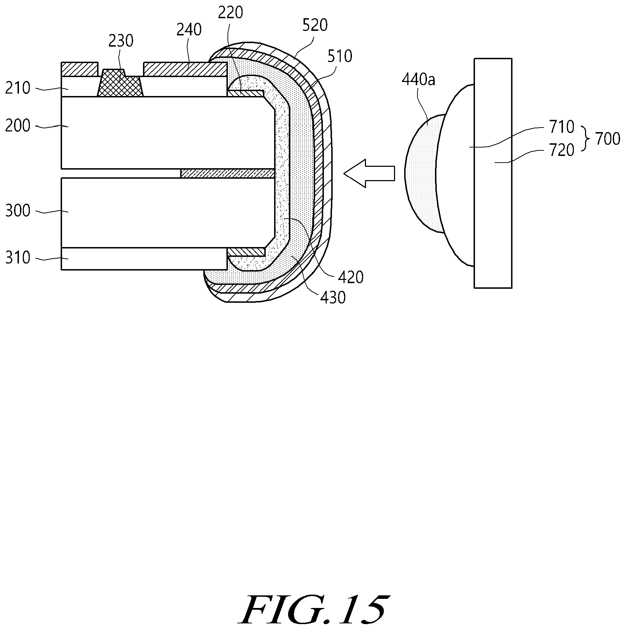

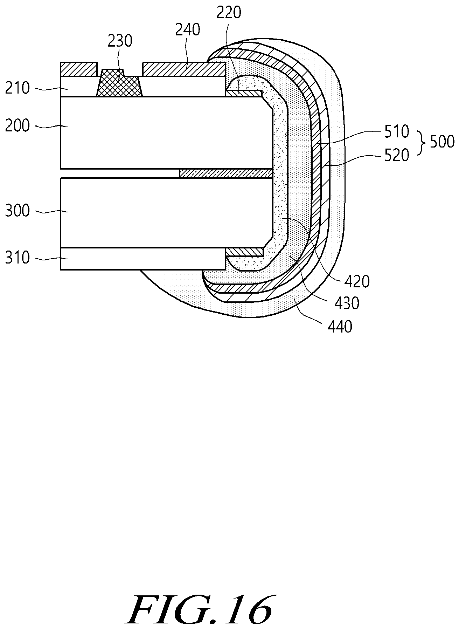

Referring to FIG. 15, a side sealing layer 440 can be formed on the side of the display panel. The side sealing layer 440 can be formed using a pad unit 700 comprising a silicone pad 710 and a head 720, and a light absorbing material 440a. Specifically, the light absorbing material 440a can be attached to the silicone pad 710, and then the pad unit 700 can be moved to the side of the display panel to move the silicone pad 710 to the side of the display panel where the side sealing layer 440 can be to be formed. Thereafter, referring to FIG. 16, the light absorbing material 440a attached to the silicone pad 710 can be transferred to the side of the display panel to form the side sealing layer 440.

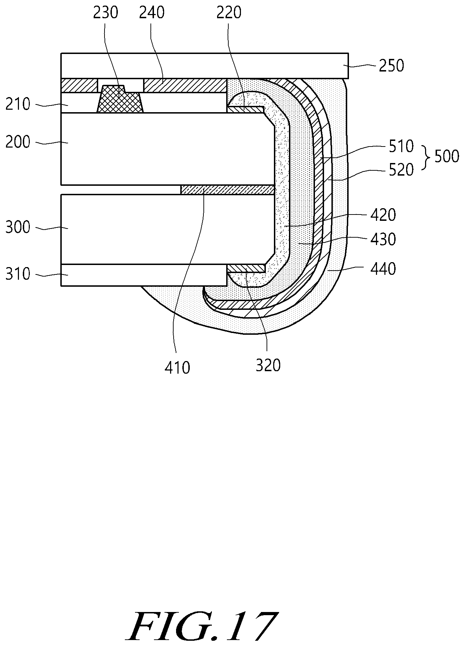

Referring to FIG. 17, a functional film layer 250 may be formed on the display panel. The functional film layer 250 may be attached to the display panel, and then its side may be cut, such that a side of the functional film layer 250 and a side of the side sealing layer 440 may be disposed on the same line.

Embodiments of the disclosure described above are briefly described below.

A display device according to embodiments of the present disclosure may comprise: a first substrate including a display area and a non-display area surrounding the display area; a light emitting device provided in the display area on the first substrate; a first pad portion provided in the non-display area on a top surface of the first substrate and disposed on one edge of the first substrate; a second substrate provided under a bottom surface of the first substrate; a second pad portion provided in the non-display area on a bottom surface of the second substrate and disposed on one edge of the second substrate; a side link line electrically connecting the first pad portion and the second pad portion; a side coating layer disposed to cover the side link line; a side protective layer disposed to cover at least a portion of the side coating layer; and a side sealing layer disposed to cover at least a portion of the side protective layer.

In a display device according to embodiments of the present disclosure, the light emitting device may be a micro LED (Light Emitting Diode).

In a display device according to embodiments of the present disclosure, the side protective layer may include a first side protective layer comprising a moisture barrier material, and a second side protective layer comprising conductive particles and a conductive polymer.

In a display device according to embodiments of the present disclosure, the moisture barrier material may comprise an aromatic hydrocarbon-based compound.

In a display device according to embodiments of the present disclosure, the aromatic hydrocarbon-based compound may be at least one selected from the following compounds:

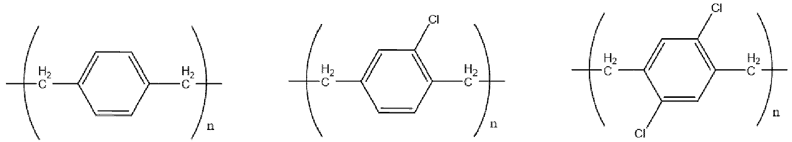

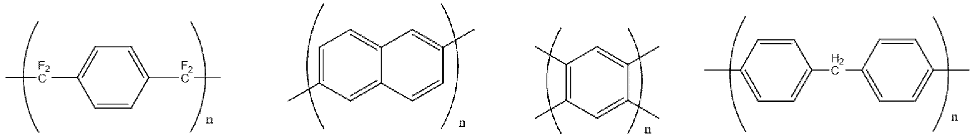

In a display device according to embodiments of the present disclosure, the conductive particles can be at least one carbon nanotube selected from single-walled carbon nanotubes, double-walled carbon nanotubes, and multi-walled carbon nanotubes.

In a display device according to embodiments of the present disclosure, the conductive polymer may be at least one selected from the group consisting of polyfluorene, polyphenylene, polypyrene, polyazulene, polynaphthalene, polyacetylene (PAC), poly(p-phenylene vinylene) (PPV), polypyrrole (PPY), polycarbazole, polyindole, polyzepine, poly(thienylene vinylene), polyaniline (PANI), poly(thiophene), poly(p-phenylene sulfide) (PPS), poly(3,4-ethylenedioxy thiophene) (PEDOT), poly(3,4-ethylenedioxy thiophene) doped with poly(styrene sulfonate) (PEDOT:PSS), poly(3,4-ethylenedioxythiophene)-tetramethacrylate (PEDOT-TMA) and polyfuran.

In a display device according to embodiments of the present disclosure, the first side protective layer may be disposed to abut the side coating layer, and the second side protective layer may be disposed to abut the first side protective layer.

In a display device according to embodiments of the present disclosure, the side protective layer may further comprise a third side protective layer including a light absorbing material.

In a display device according to embodiments of the present disclosure, the light absorbing material may include a black ink including at least one of carbon black, a black dye and a black pigment.

In a display device according to embodiments of the present disclosure, the second side protective layer may be disposed to abut the side coating layer, the third side protective layer may be disposed to abut the second side protective layer, and the first side protective layer may be disposed to abut the third side protective layer.

In a display device according to embodiments of the present disclosure, the side protective layer may include a first side protective layer comprising a moisture barrier material, and a fourth side protective layer comprising conductive particles and black rubber.

In a display device according to embodiments of the present disclosure, the moisture barrier material may comprise an aromatic hydrocarbon-based compound.

In a display device according to embodiments of the present disclosure, the aromatic hydrocarbon-based compound may be at least one selected from the following compounds:

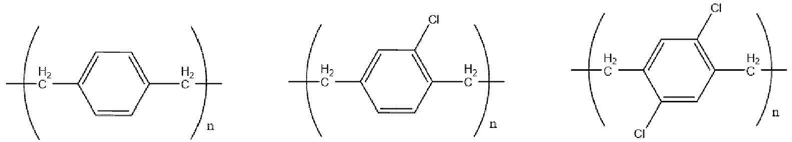

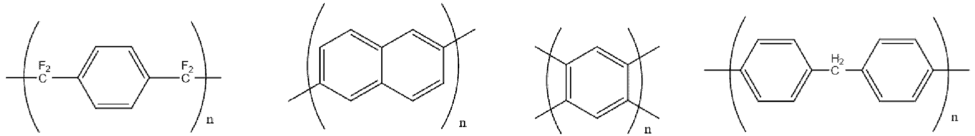

In a display device according to embodiments of the present disclosure, the conductive particles may be at least one carbon nanotube selected from single-walled carbon nanotubes, double-walled carbon nanotubes, and multi-walled carbon nanotubes.

In a display device according to embodiments of the present disclosure, the black rubber may include at least one of carbon black, a black dye and a black pigment, and an isoprene-based rubber.

In a display device according to embodiments of the present disclosure, the first side protective layer may be disposed to abut the side coating layer, and the fourth side protective layer may be disposed to abut the first side protective layer.

In a display device according to embodiments of the present disclosure, the fourth side protective layer may be disposed to abut the side coating layer, and the first side protective layer may be disposed to abut the fourth side protective layer.

In a display device according to embodiments of the present disclosure, the side link line may include a conductive paste.

In a display device according to embodiments of the present disclosure, the side coating layer may include a black ink comprising at least one of carbon black, a black dye and a black pigment.

In a display device according to embodiments of the present disclosure, the side sealing layer may include at least one of carbon black, a black dye and a black pigment.

A display device according to embodiments of the present disclosure may further include a functional film layer, and a side end of the functional film layer and a side end of the side sealing layer may be disposed on the same line.

A display device according to embodiments of the present disclosure may further include an adhesive layer disposed between the first and second substrates.

In a display device according to embodiments of the present disclosure, the side protective layer may include one or more of a moisture barrier material, a conductive material and a light absorbing material.

A display device according to embodiments of the present disclosure may fu rther comprise: a third layer disposed on the bottom surface of the second substrate; a cover bottom disposed on a bottom surface of the third layer; and an adhesive pad disposed between the third layer and the cover bottom.

A tiled display device according to embodiments of the present disclosure may include a plurality of display modules, each of the plurality of display modules comprising: a first substrate including a display area and a non-display area surrounding the display area; a light emitting device provided in the display area on the first substrate; a first pad portion provided in the non-display area on a top surface of the first substrate and disposed on one edge of the first substrate; a second substrate provided under a bottom surface of the first substrate; a second pad portion provided in the non-display area on a bottom surface of the second substrate and disposed on one edge of the second substrate; a side link line electrically connecting the first pad portion and the second pad portion; a side coating layer disposed to cover the side link line; a side protective layer disposed to cover at least a portion of the side coating layer; and a side sealing layer disposed to cover at least a portion of the side protective layer.

A tiled display device according to one or more embodiments of the present disclosure may include a plurality of display modules, each of the plurality of display modules comprising a display device according to one or more embodiments described herein.

## Claims

1. A display device (100) comprising:
a first substrate (200) including a display area (AA) and a non-display area (NA) surrounding the display area (AA);
a light emitting device (230) provided in the display area (AA) on the first substrate (200);
a first pad portion (220) provided in the non-display area (NA) on a top surface of the first substrate (200) and disposed on one edge of the first substrate (200);
a second substrate (300) provided under a bottom surface of the first substrate (200);
a second pad portion (320) provided in the non-display area (NA) on a bottom surface of the second substrate (300) and disposed on one edge of the second substrate (300);
a side link line (420) electrically connecting the first pad portion (220) and the second pad portion (320);
a side coating layer (430) disposed to cover the side link line (420);
a side protective layer (500) disposed to cover at least a portion of the side coating layer (430); and
a side sealing layer (440) disposed to cover at least a portion of the side protective layer (500).

2. The display device (100) of claim 1, wherein the light emitting device (230) is a micro LED.

3. The display device (100) of claim 1 or 2, wherein the side protective layer (500) comprises:
a first side protective layer (510) comprising a moisture barrier material; and
a second side protective layer (520) comprising conductive particles and a conductive polymer.

4. The display device (100) of claim 3, wherein the moisture barrier material comprises an aromatic hydrocarbon-based compound,
wherein, preferably, the aromatic hydrocarbon-based compound is at least one selected from the following compounds:

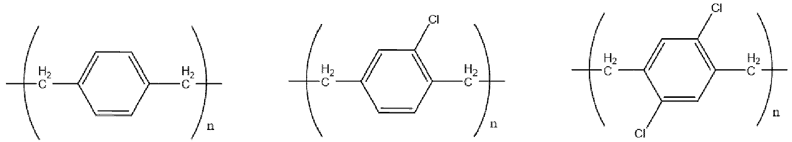

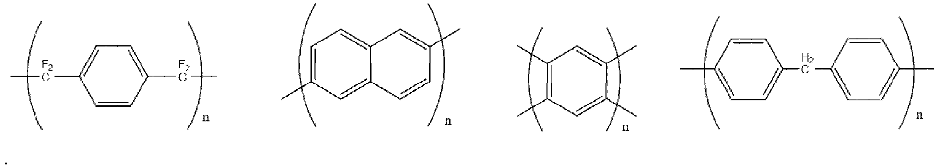

5. The display device (100) of claim 3 or 4, wherein the conductive particles are at least one carbon nanotube selected from single-walled carbon nanotubes, double-walled carbon nanotubes, and multi-walled carbon nanotubes.

6. The display device (100) of any of claims 3 to 5, wherein the conductive polymer is at least one selected from the group consisting of polyfluorene, polyphenylene, polypyrene, polyazulene, polynaphthalene, polyacetylene (PAC), poly(p-phenylene vinylene) (PPV), polypyrrole (PPY), polycarbazole, polyindole, polyzepine, poly(thienylene vinylene), polyaniline (PANI), poly(thiophene), poly(p-phenylene sulfide) (PPS), poly(3,4-ethylenedioxy thiophene) (PEDOT), poly(3,4-ethylenedioxy thiophene) doped with poly(styrene sulfonate) (PEDOT:PSS), poly(3,4-ethylenedioxythiophene)-tetramethacrylate (PEDOT-TMA) and polyfuran.

7. The display device (100) of any of claims 3 to 6, wherein the first side protective layer (510) is disposed to abut the side coating layer (430), and the second side protective layer (520) is disposed to abut the first side protective layer (510).

8. The display device (100) of any of claims 3 to 6, wherein the side protective layer (500) comprises a third side protective layer (530) including a light absorbing material,
wherein, preferably, the light absorbing material comprises a black ink comprising at least one of carbon black, a black dye and a black pigment.

9. The display device (100) of claim 8,
wherein the second side protective layer (520) is disposed to abut the side coating layer (430),
wherein the third side protective layer (530) is disposed to abut the second side protective layer (520), and
wherein the first side protective layer (510) is disposed to abut the third side protective layer (530).

10. The display device (100) of claim 1 or 2, wherein the side protective layer (500) comprises:
a first side protective layer (510) comprising a moisture barrier material, and
a fourth side protective layer (540) comprising conductive particles and black rubber.

11. The display device (100) of claim 10, wherein:
the first side protective layer (510) is disposed to abut the side coating layer (430), and the fourth side protective layer (540) is disposed to abut the first side protective layer (510); or wherein:
the fourth side protective layer (540) is disposed to abut the side coating layer (430), and the first side protective layer (510) is disposed to abut the fourth side protective layer (540).

12. The display device (100) of any of claims 1 to 11, wherein the side link line (420) comprises a conductive paste, and/or wherein the side coating layer (430) comprises a black ink comprising at least one of carbon black, a black dye and a black pigment, and/or wherein the side sealing layer (440) comprises at least one of carbon black, a black dye and a black pigment.

13. The display device (100) of any of claims 1 to 12, further comprising:
a functional film layer (250), wherein a side end of the functional film layer (250) and a side end of the side sealing layer (440) are disposed on the same line; and/or
an adhesive layer (410) disposed between the first and second substrates (200, 300).

14. The display device (100) of any of claims 1 to 13, further comprising:
a third layer (310) disposed on the bottom surface of the second substrate (300);
a cover bottom (620) disposed on a bottom surface of the third layer (310); and
an adhesive pad (610) disposed between the third layer (310) and the cover bottom (620).

15. A tiled display device comprising a plurality of display modules, wherein each of the plurality of display modules (DM1, DM2, DM3, DM4) comprises the display device (100) of any of claims 1 to 14.
